# EUROPEAN PATENT APPLICATION

(11) **EP 3 416 290 A1**
(43) Date of publication of application: **19.12.2018**
(21) Application number: 17176169.5
(22) Date of filing: 15.06.2017
(51) Int. Cl.: H03K 17/20, H03K 17/785

(54) **ASSEMBLY FOR CONTROLLING GATE-CONTROLLED SWITCH**

(71) Applicant: ABB Technology Oy, 00380 Helsinki (FI)
(72) Inventor: Niemi, Mika, 00380 Helsinki (FI); Kohvakka, Mikko, 00380 Helsinki (FI)
(74) Representative: Kolster Oy Ab

(57) **Abstract**

An assembly for controlling a gate-controlled switch, the assembly comprising a gate driver (GDR) and a gate adapter (GAD). Forming a gate driver signal (SG14) with the gate driver (GDR) comprises combining a gate control signal (SG12) with a protection signal, the protection signal being an alternating signal that alternates between a first signal level and a second signal level, the first signal level is such that combining the first signal level with the gate control signal (SG12) retains state of the gate control signal (SG12) unchanged, while the second signal level is such that combining the second signal level with the gate control signal (SG12) provides a safe torque off state for the gate driver signal (SG14). The gate adapter (GAD) is adapted to drive the gate of the gate-controlled switch (CS) into a safe state if the gate adapter (GAD) does not receive information of the protection signal.

## Description

### FIELD OF THE INVENTION

The invention relates to controlling of a gate-controlled switch, and more particularly to implementation of safe torque off function.

### BRIEF DESCRIPTION OF THE INVENTION

An object of the present invention is to provide an assembly for controlling a gate-controlled switch which can reliably implement safe torque off function. The object of the invention is achieved by an assembly which is characterized by what is stated in the independent claim. The preferred embodiments of the invention are disclosed in the dependent claims.

The invention is based on the idea of providing an assembly which is adapted to control a gate-controlled switch into a safe state both with a specific safe torque off (STO) command and in a situation where a protection signal is missing from a gate driver signal, the protection signal being an alternating signal. A gate adapter of the assembly is adapted to drive the gate of the gate-controlled switch into the safe state if the gate adapter does not receive information of the protection signal. During normal operation of the assembly the gate driver signal alternates fast between a target state and a STO state, the target state being for example a turn on state, turn off state or soft turn off state.

An advantage of the assembly of the invention is that the STO function is reliable and redundant.

### BRIEF DESCRIPTION OF THE DRAWINGS

In the following the invention will be described in greater detail by means of preferred embodiments with reference to the attached drawings, in which
Figure 1 shows an assembly according to an embodiment of the invention;
Figure 2 shows sections of the assembly of Figure 1 in more detail; and
Figure 3 shows a supply voltage generation device of the assembly of Figure 1.

### DETAILED DESCRIPTION OF THE INVENTION

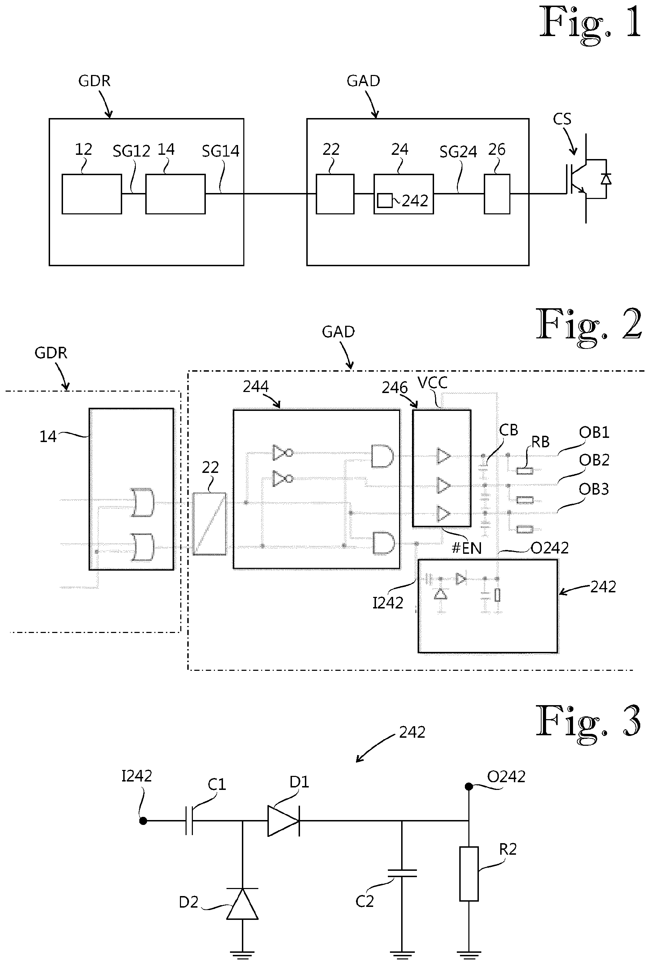

Figure 1 shows an assembly for controlling a gate-controlled switch, the assembly comprising a gate driver GDR and a gate adapter GAD. Figure 1 also shows a gate-controlled switch CS adapted to be controlled by the assembly.

The gate driver GDR comprises a gate controller 12 and a protection signal combiner 14. The gate controller 12 is adapted to form a gate control signal SG12 for controlling a gate of the gate-controlled switch CS. The gate control signal SG12 comprises a digital two bit signal. The gate controller 12 is adapted to provide the gate control signal SG12 with a state selected from a plurality of command states. The plurality of command states comprises turn on state, turn off state, soft turn off state and a safe torque off state.

The gate-controlled switch CS is an insulated-gate bipolar transistor, or IGBT. In an alternative embodiment the gate-controlled switch is another type of gate-controlled switch such as a thyristor or MOSFET.

The protection signal combiner 14 is adapted to form a gate driver signal SG14 by combining the gate control signal SG12 with a protection signal. Information of the gate control signal SG12 and the protection signal are embedded in the gate driver signal SG14. The protection signal is an alternating signal that alternates between a first signal level and a second signal level, the first signal level is such that combining the first signal level with the gate control signal SG12 retains state of the gate control signal SG12 unchanged, while the second signal level is such that combining the second signal level with the gate control signal SG12 provides the safe torque off state for the gate driver signal SG14.

In alternative embodiments the protection signal has three or more signal levels. Herein such signals are interpreted as alternating signals that alternate between a first signal level and a second signal level, as long as there are at least two repeated signal levels. In other words it is irrelevant whether the alternating signal has two or more signal levels, as long as the alternating signal comprises two signal levels that are repeated during the signal.

The gate driver signal SG14 comprises a two bit signal which includes bit 0 and bit 1. Each of the bit 0 and bit 1 can have only one of two values. The first signal level is produced by value 0, and the second signal level is produced by value 1.

Frequency of the protection signal is higher than switching frequency of the controllable switch CS. In an embodiment frequency of the protection signal is at least ten times as high as switching frequency of the controllable switch CS. For example, switching frequency of the controllable switch can be in the range of 1 - 50 kHz, and frequency of the protection signal can be in the range of 1 - 100 MHz. In an alternative embodiment switching frequency of the controllable switch is 2 kHz and frequency of the protection signal is 20 kHz.

The protection signal combiner 14 is adapted to form the gate driver signal SG14 by injecting the protection signal into the gate control signal SG12 by using OR gates. In an alternative embodiment a gate driver is adapted to inject a gate control signal into a protection signal.

During normal operation of the assembly the gate driver signal SG14 alternates fast between a target state and the safe torque off state. The target state is the turn on state, the turn off state or the soft turn off state. The gate driver signal SG14 is adapted to be in a stationary state only when the gate control signal SG12 has the safe torque off state.

The gate adapter GAD is adapted to receive the gate driver signal SG14, form a gate adapter signal SG24 as a response to the gate driver signal SG14, and drive the gate of the gate-controlled switch CS with information of the gate adapter signal SG24. The gate adapter GAD is adapted to operate at the gate potential of the gate-controlled switch CS. The gate adapter GAD comprises an isolator 22, a decoding logic 24 and an amplifier 26. The decoding logic 24 is located downstream in signal direction compared with the isolator 22. The decoding logic 24 comprises a supply voltage generation device 242.

The isolator 22 is adapted to galvanically isolate the gate driver signal SG14 from the gate adapter signal SG24. The isolator 22 is adapted to retain information in the signal passing therethrough unchanged. In an embodiment the isolator comprises an optical isolator. In another embodiment the isolator comprises a digital isolator. The isolator is only necessary in embodiments where electrical isolation between the gate driver signal and the gate adapter signal is required.

The decoding logic 24 is adapted to decode information of the gate control signal SG12 and the protection signal from the gate driver signal SG14. The decoding logic 24 is adapted to decode information of the gate control signal SG12 such that command state turn on of the gate control signal SG12 corresponds to command state turn on of the gate adapter signal SG24, command state turn off of the gate control signal SG12 corresponds to command state turn off of the gate adapter signal SG24, command state soft turn off of the gate control signal SG12 corresponds to command state soft turn off of the gate adapter signal SG24, and command state safe torque off of the gate control signal SG12 corresponds to command state soft turn off of the gate adapter signal SG24. The decoding logic 24 is adapted to form the gate adapter signal SG24, and to supply the information of the protection signal to the supply voltage generation device 242.

Table 1 below presents truth table of the decoding logic 24. The table 1 shows how four command states of the gate driver signal SG14 are produced by the two bit signal. As explained above, during normal operation of the assembly the gate driver signal SG14 alternates between a target state and the safe torque off state. According to Table 1, if the target state is the turn on state, the gate driver signal SG14 alternates between values "1-0" and "1-1".

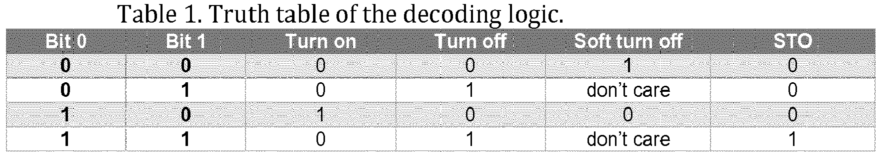

In another embodiment the gate control signal has more than four command states. For example, eight command states can be produced by using a three bit gate control signal.

In addition to the supply voltage generation device 242, the decoding logic 24 also comprises logic circuit 244, a buffer 246, buffer capacitors CB and buffer resistors RB. The buffer 246 is a 3-state buffer having three output terminals denoted as OB1, OB2 and OB3. The buffer 246 is located downstream in signal direction compared with the logic circuit 244.

There is a buffer capacitor CB and a buffer resistor RB per each of the output terminals. Each buffer capacitor CB is electrically connected between a corresponding output terminal of the buffer 246 and ground potential. Each buffer resistor RB is electrically connected between a corresponding output terminal of the buffer 246 and ground potential. In alternative embodiments the gate adapter comprises pull up resistors or pull down resistors adapted to pull output of the buffer to a safe state in case the gate adapter does not receive information of the protection signal.

Output terminal OB1 is adapted to deliver soft turn off signal. Output terminal OB2 is adapted to deliver turn on signal. Output terminal OB3 is adapted to deliver turn off signal. The decoding logic 24 comprises a signal adaptation block (not depicted) which is adapted to convert information of the output terminals OB1, OB2 and OB3 into the gate adapter signal SG24. The amplifier 26 is a power amplifier adapted to amplify signal level of a signal passing therethrough to a level suitable for the gate of the gate-controlled switch CS. The amplifier 26 does not modify information of a signal passing therethrough, the amplifier 26 only amplifies the signal.

An input I242 of the supply voltage generation device 242 is connected to the same output terminal of the logic circuit 244 as an input pin #EN of the buffer 246. The input pin #EN of the buffer 246 is an enable input pin that is able to set output of the buffer 246 into high impedance state. An output 0242 of the supply voltage generation device 242 is connected to a positive supply voltage pin VCC of the buffer 246.

Figure 3 shows that the supply voltage generation device 242 comprises capacitors C1 and C2, diodes D1 and D2, and resistor R2. Capacitor C1 is connected between the input I242 of the supply voltage generation device 242 and the anode of the diode D1. Capacitor C2 is connected between the output 0242 of the supply voltage generation device 242 and ground potential. The cathode of the diode D1 is connected to the output 0242 of the supply voltage generation device 242. The cathode of the diode D2 is connected to the anode of the diode D1. The anode of the diode D2 is connected to ground potential. Resistor R2 is connected between the output 0242 of the supply voltage generation device 242 and ground potential.

Capacitance of the capacitor C1 is 10 nF. Capacitance of the capacitor C2 is 5 µF. Diodes D1 and D2 are BAT54 Schottky diodes. Resistance of the resistor R2 is 900 Ω.

The supply voltage generation device 242 is adapted to generate a supply voltage required by the gate adapter GAD for forming the gate adapter signal SG24 as a response to the gate driver signal SG14, wherein in the absence of the supply voltage the gate adapter GAD is adapted to drive the gate of the gate-controlled switch CS into a safe state. The supply voltage generation device 242 requires reception of the information of the protection signal for forming the supply voltage. If the protection signal is stuck to the first signal level or the second signal level, or if the protection signal is missing, the supply voltage dies out, and the gate adapter signal SG24 goes into a safe state due to the buffer resistors RB. It should be noted that alternation of the gate control signal SG12 cannot achieve generation of the supply voltage because maximum frequency of the gate control signal SG12 is substantially lower than frequency of the protection signal, and only safe torque off state can generate input voltage to the supply voltage generation device 242.

In the embodiment of Figure 1 the safe state, into which the gate adapter GAD is adapted to control the gate of the gate-controlled switch CS in the absence of the supply voltage, is the soft turn off state. Further, the gate adapter GAD is adapted to provide the gate adapter signal SG24 with the soft turn off state as a response to the gate driver signal SG14 having the safe torque off state. In an alternative embodiment the safe state is the turn off state.

It will be obvious to a person skilled in the art that the inventive concept can be implemented in various ways. The invention and its embodiments are not limited to the examples described above but may vary within the scope of the claims.

## Claims

1. An assembly for controlling a gate-controlled switch, the assembly comprising:
a gate driver (GDR) adapted to form a gate driver signal (SG14), the gate driver signal (SG14) comprising a gate control signal (SG12) for controlling a gate of a gate-controlled switch (CS), the gate driver (GDR) being adapted to provide the gate driver signal (SG14) with a state selected from a plurality of command states comprising turn on state and turn off state; and
a gate adapter (GAD) adapted to receive the gate driver signal (SG14), form a gate adapter signal (SG24) as a response to the gate driver signal (SG14), and drive the gate of the gate-controlled switch (CS) with information of the gate adapter signal (SG24),
**characterized in that** the plurality of command states comprises a safe torque off state, and
forming the gate driver signal (SG14) with the gate driver (GDR) comprises combining the gate control signal (SG12) with a protection signal, the protection signal being an alternating signal that alternates between a first signal level and a second signal level, the first signal level is such that combining the first signal level with the gate control signal (SG12) retains state of the gate control signal (SG12) unchanged, while the second signal level is such that combining the second signal level with the gate control signal (SG12) provides the safe torque off state for the gate driver signal (SG14), and
the gate adapter (GAD) comprises a supply voltage generation device (242) which is adapted to generate a supply voltage required by the gate adapter (GAD) for forming the gate adapter signal (SG24) as a response to the gate driver signal (SG14), wherein in the absence of the supply voltage the gate adapter (GAD) is adapted to drive the gate of the gate-controlled switch (CS) into a safe state, and
wherein the supply voltage generation device (242) requires reception of the information of the protection signal for forming the supply voltage.

2. An assembly according to claim 1, **characterized in that** said safe state is a soft turn off state or a turn off state.

3. An assembly according to claim 1 or 2, **characterized in that** the assembly comprises an isolator (22) adapted to electrically isolate the gate driver signal (SG14) from the gate adapter signal (SG24).

4. An assembly according to claim 3, **characterized in that** the isolator (22) comprises an optical or digital isolator.

5. An assembly according to any one of the preceding claims, **characterized in that** the gate adapter (GAD) comprises a decoding logic (24) adapted to decode information of the gate control signal (SG12) and the protection signal from the gate driver signal (SG14).

6. An assembly according to claim 5, **characterized in that** the decoding logic (24) is adapted to form the gate adapter signal (SG24).

7. An assembly according to any one of preceding claims, **characterized in that** each of the gate control signal (SG12) and the gate driver signal (SG14) comprise a two bit signal.

8. An assembly according to any one of preceding claims, **characterized in that** frequency of the protection signal is higher than switching frequency of the controllable switch (CS).

9. An assembly according to claim 8, **characterized in that** the frequency of the protection signal is at least ten times the switching frequency of the controllable switch (CS).
